# EUROPEAN PATENT APPLICATION

(11) **EP 3 972 397 A1**
(43) Date of publication of application: **23.03.2022**
(21) Application number: 21195620.6
(22) Date of filing: 08.09.2021
(51) Int. Cl.: H05K 5/00, H05K 7/20

(54) **ADJUSTABLE SECURED HEATSINK ASSEMBLY**

(30) Priority: 16.09.2020 US 202017022202
(71) Applicant: BAE Systems Controls Inc., Endicott, New York 13760 (US)
(72) Inventor: GEHM, William J., Lisle, NY 13797 (US); MARCO, Nick C., Susquehanna, PA 18847-9541 (US)
(74) Representative: BAE SYSTEMS plc Group IP Department

(57) **Abstract**

A heat sink assembly includes a thermally conductive support member configured to be attached to a heat source and a heat sink. An adjustable mechanism is configured to moveably connect the thermally conductive support member to the heat sink. The adjustable mechanism permits the heat source to be moved relative to the heat sink without requiring access to the adjustable mechanism. The heat sink assembly provides a mechanically adjustable and supportive system having a thermally conductive path for heat removal from the object. The integral movable adjustment mechanism permits the thermally conductive member to translate without loss of the thermal path between the two ends. The heat source can move and become rigidly fixed in location without direct access. A compression mechanism may provide a continuous force between the support member and the heat sink as the support member is translated to permit movement of the heat generating source.

## Description

### BACKGROUND

The present invention relates to a heat sink assembly and more particularly to an assembly having an adjustable feature permitting the heat source to be moved relative to the heat sink.

Many electronic assemblies have heat sources that require removal of heat from the source by providing a thermally conductive path between the source and a heat sink located near the source. Some assemblies require the heat source to be moved as a part of the overall assembly process and then fixed in place with the final assembly requiring that the thermal path be efficient in the removal of heat from the source. The requirement to move the physical location of the heat source relative to the location of the heat sink typically requires both an adjustment feature and direct access to the feature to ensure all is properly secured upon completion of the final assembly.

### BRIEF SUMMARY

In one embodiment, a heat sink assembly includes a thermally conductive support member configured to be attached to a heat source and a heat sink, the heat source being located within an enclosure. An adjustable mechanism is configured to moveably connect the thermally conductive support member to the heat sink. The adjustable mechanism permits the heat source to be moved relative to the heat sink without requiring access within the enclosure to the adjustable mechanism.

In one embodiment, the heat sink assembly provides a mechanically adjustable and supportive system having a thermally conductive path for heat removal from the object. The thermally conductive member attaches to the heat source at one end and to the heat sink at another end with the integral movable adjustment mechanism permitting the thermally conductive member to translate without loss of the thermal path between the two ends. The mechanically adjustable thermally conductive member can move and become fixed in position without direct access.

In one embodiment, the adjustable end of the thermally conductive support member is maintained in thermal contact with the heat sink with a compression mechanism providing a continuous force between the thermally conductive support member and the heat sink as the thermally conductive support member is translated to permit movement of the heat generating source.

### BRIEF DESCRIPTION OF THE DRAWINGS

Figure 1 is an isometric view of one embodiment of a heat sink assembly of the present disclosure.
Figure 2 is a close up isometric view of one embodiment of a tongue and groove joint and spring clips of a heat sink assembly of the present disclosure.
Figure 3 is a close up isometric view of one embodiment of a thermal conductive support member of a heat sink assembly of the present disclosure.
Figure 4 is an exploded view of one embodiment of a heat sink assembly of the present disclosure.
Figure 5 is an isometric view of a completed assembly containing the heat sink assembly of the present disclosure.
Figure 6 is an isometric view of one embodiment of a compression mechanism of a heat sink assembly of the present disclosure.
Figure 7 is an isometric view of one embodiment of a compression mechanism of a heat sink assembly of the present disclosure.
Figure 8 is an isometric view of one embodiment of a combination of a flexible thermal strap connected between a heat sink and a thermally conductive bracket of a heat sink assembly of the present disclosure.
Figure 9 is a flow diagram of one embodiment of a method of removing of heat from an object using a heat sink assembly of the present disclosure.

Further features as well as the structure and operation of various embodiments are described in detail below with reference to the accompanying drawings. In the drawings, like reference numbers indicate identical or functionally similar elements.

### DETAILED DESCRIPTION

In one embodiment, a heat sink assembly includes a thermally conductive support member fastened to a heat generating structure. The thermally conductive support member is operably adjustable at an opposing end while maintaining direct thermal contact with another structure providing a heat sink. The thermally conductive support member provides the necessary structural integrity to maintain the desired position of the heat generating source relative to the intended final assembled configuration. In one embodiment, the adjustable end of the thermally conductive support member is maintained in thermal contact with the heat sink with a compression mechanism providing a continuous force between the thermally conductive support member and the heat sink as the thermally conductive support member is translated to permit movement of the heat generating source. In the final completed assembly of the heat generating source, thermally conductive support member and heat sink within an enclosure is accomplished without direct access within the enclosure to the support and pressure features during the assembly process.

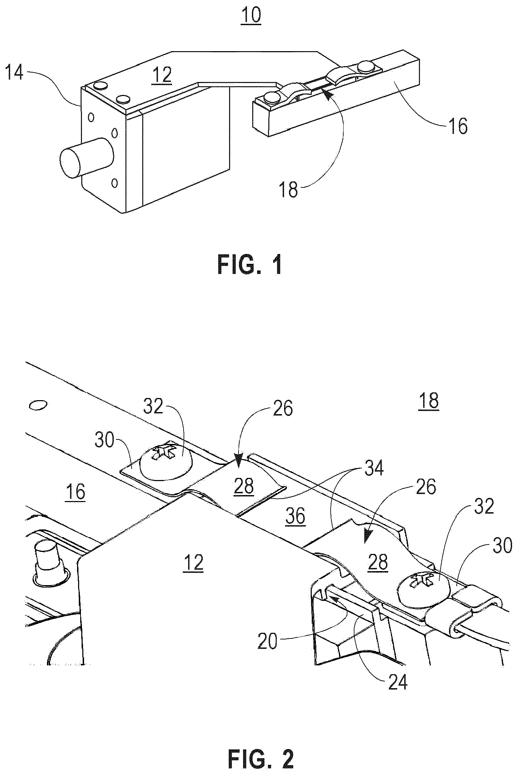

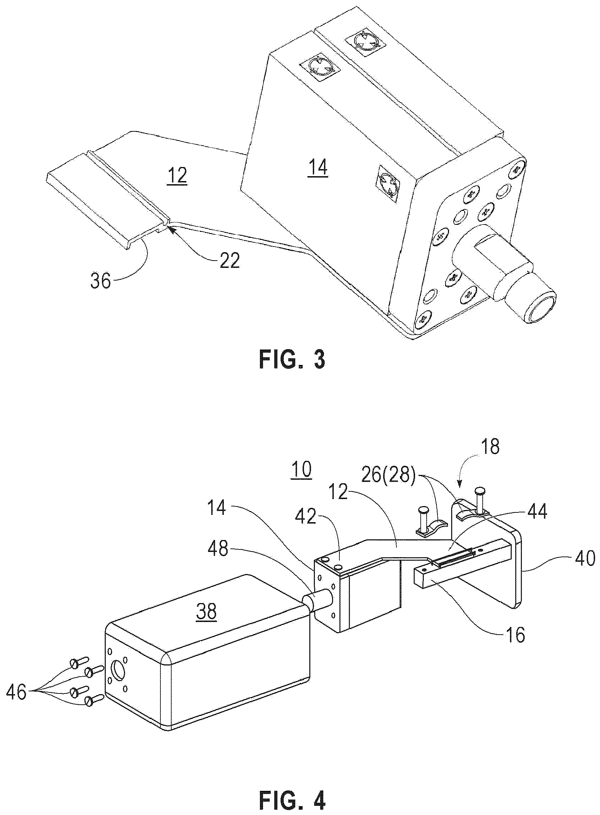

Figure 1 is an isometric view of one embodiment of a heat sink assembly of the present disclosure. The heat sink assembly 10 includes thermally conductive support member 12 configured to be attached to a heat generating source 14. The thermally conductive support member 12 is also configured to be attached to a heat sink 16. The heat sink assembly 10 includes an adjustable mechanism 18 permitting the thermally conductive support member 12 to be moved relative to the heat sink 16. As shown in Figure 2, the adjustable connector 18 is comprised of a tongue and groove joint 20. In one embodiment, the tongue and groove joint 20 is formed by a groove 22 on the support member 12 (best seen in Figure 3) that fits on a rib 24 on the heat sink 16. The tongue and groove joint 20 permits the thermally conductive support member 12 to be translated on the heat sink 16 to permit movement of the heat generating source 14.

In one embodiment, the thermally conductive support member 12 is maintained in continuous thermal contact with the heat sink 16 with a compression mechanism 26 that provides a continuous force between the thermally conductive support member 12 and the heat sink 16 as the thermally conductive support member 12 is translated to move the heat generating source 14. In one embodiment, the compression mechanism 26 includes a pair of spring clips 28. One end 30 of the spring clips 28 is secured to the heat sink 16 by for example fasteners 32. The other end 34 of the springs clips 28 provides a clamping force onto a channel 36 provided on the support member 12. The amount of translational movement of the support member 12 is limited by the fastened end 30 of the clips 28.

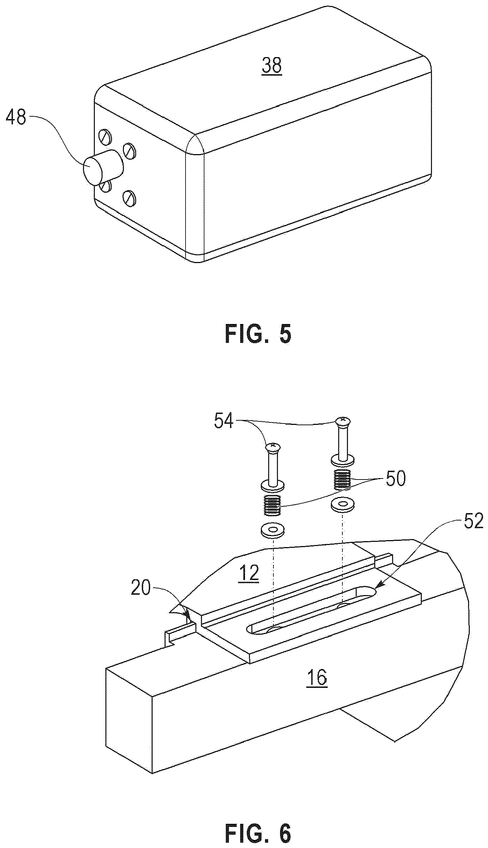

Figure 4 provides an exploded view of one embodiment showing heat sink assembly 10, including the heat generating source 14 is to be installed in a housing 38. This is an example of how the adjustable mechanism 18 of the heat sink assembly is configured permit the heat generating source 14 to be moved relative to the heat sink 16 without requiring access within the housing 38 to the adjustable mechanism 18 when the heat generating source 14 is installed within the housing 38. In this embodiment, the heat generating source 14 is for example an electronic/electrical component, the thermal conductive support member 12 is for example a metal bracket, clamping members 26 are for example spring clips 28 and the heat sink 16 is for example a heat sink rail. A panel 40 of the housing 38 is attached to the heat sink rail 16. The panel 40 may also serve as an additional heat sink. One end 42 of metal bracket 12 is rigidly fixed to the component 14, for example with threaded fasteners. The other end 44 of the metal bracket 12 can slide along the rib 24 of the tongue and groove joint 20 to ensure linear travel when the component 14 is installed in the housing 38. The thermally conductive bracket 12 extends towards the thermally conductive heat sink 16 and the channel 36 provides a mechanically adjustable interface allowing the heat sink 16 to translate with respect to the interface. The pair of spring clips 28 provides a continuous downward clamping force to both maintain the metal bracket 12 in intimate thermal contact with the heat sink rail 16 and to ensure the mechanical position of the metal bracket 12 relative to the heat rail 16 as the metal bracket 12 is slid along the rib 24. Thus, the adjustable mechanism 18 of heat sink assembly 10 permits the movement needed to properly assemble the subassembly 14 into the housing 38 to form the final package and provide the required thermal conductive path without requiring access within the housing 38 to the heat sink assembly 10. In the final assembled position, the component 14 is secured to the housing 38 by fasteners 46. Figure 5 shows one embodiment of a completed assembly in which a portion 48 of the component 14 protrudes from the housing 38.

In one embodiment, the component 14 is pressure transducer sub-assembly of an engine control system and the heat sink assembly 10 provides a thermally conductive path with adjustable location for the pressure transducer. The pressure transducer subassembly 14 generates heat by dissipating power during operation and therefore that requires cooling to provide continuous proper operation. The subassembly 14 is attached to a structure that is not thermally conductive therefore not providing a means of removing the heat from the subassembly 14. The assembly of the subassembly into the final package requires that any added thermal path to the heat sink 16 needs to be adjustable in order to allow movement of the subassembly 14 when being installed into the housing 38. The adjustable mechanism 18 of heat sink assembly 10 permits the movement needed to properly assemble the subassembly 14 into the housing 38 to form the final package and provide the required thermal conductive path without requiring access within the housing 38 to the heat sink assembly 10.

In one embodiment, the thermally conductive bracket 12 may be made of copper or a nickel plated copper and the heat sink 16 may be aluminum. The spring clips 28 may be AISI 1050 Steel, Rc 42-46, Sn-Pb plated.

Figure 6 shows an alternative embodiment in which the compression mechanism 26 includes a pair of coil spring elements 50 that are secured through a slot 52 in the thermally conductive support member 12 using fasteners 54. Spring washers may used in place of the coil springs 50. The coil spring elements or Spring washers 50 provide the compressive downward pressure load on the thermally conductive support member 12 to ensure thermal conduction with the heat sink rail 16. The slot 52 permits the compression mechanism 26 to translate as the thermally conductive support member 12 is translated on the heat sink rail 16 using the tongue and groove joint 20.

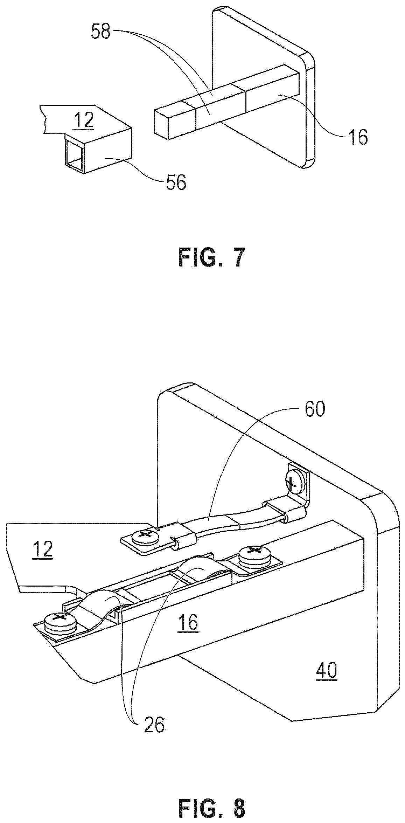

Figure 7 shows an alternative embodiment in which the adjustable member 18 includes a tube portion 56 formed on the thermally conductive support member 12 that tightly fits onto a thermally conductive material layer 58 surrounding a section of the heat sink rail 16. The tube portion 56 may be attached to or integral with the thermally conductive support member 12. The thermally conductive material layer 58 may be a thermal grease layer, thermal paste or equivalent thermally conductive material. The layer 58 may alternatively be a layer of fluid fill material. The layer 58 may alternatively be a wavy ribbon material that is compressed when the tube 56 is positioned over the layer 58. The layer 58 provides a tight tolerance compressive fit between the tube 56 and heat sink rail 16 to aid in thermal conduction while also allowing translation of the thermally conductive support member 12. The shape of the tube 56 and heat sink rail 16 can any suitable shape such as square, rectangle, round or other shape.

Figure 8 shows one embodiment of a combination of a flexible thermal strap 60 connected between the heat sink 16 and the thermally conductive bracket 12. In one embodiment, the thermal strap 60 is attached to the thermally conductive support member 12 on one end and to the enclosure panel 40 on the other end. The thermal strap 60 can be a flexible braided copper or any thermally conductive flexible material. The thermal strap 60 provides an additional thermally conductive path between the heat sink panel 40 and the metal bracket 12.

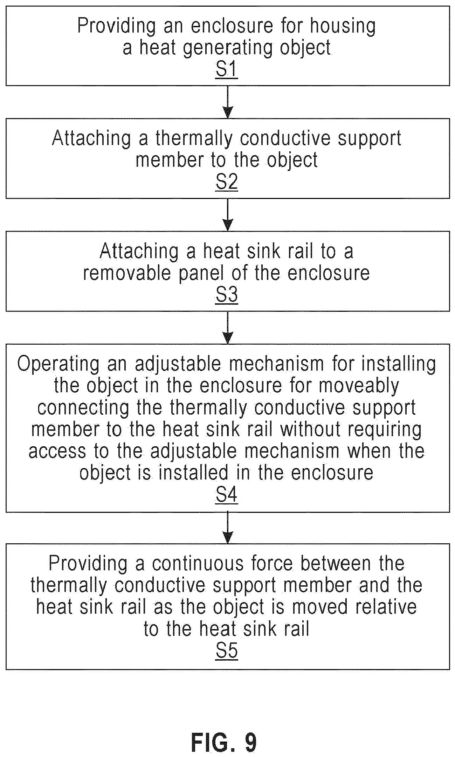

Figure 9 is a flow diagram of one embodiment of a method of removing of heat from an object. The method includes step S1 of providing an enclosure for housing an object that generates heat to be removed. In step S2 a thermally conductive support member is attached to the object. In step S3, a heat sink rail is attached to a removable panel of the enclosure. In one embodiment, the removable panel also serves as a heat sink. Step S4 includes operating an adjustable mechanism for installing the object in the enclosure. In one embodiment, the adjustable mechanism is for moveably connecting the thermally conductive support member to the heat sink rail. The adjustable mechanism permits the object to be moved relative to the heat sink rail without requiring access to the adjustable mechanism when the object is installed in the enclosure. In one embodiment, the method may include step S5 of providing a compression mechanism configured for providing a continuous force between the thermally conductive support member and the heat sink rail as the object is moved relative to the heat sink rail.

While the present invention has been particularly shown and described with respect to preferred embodiments thereof, it will be understood by those skilled in the art that the foregoing and other changes in forms and details may be made without departing from the spirit and scope of the present invention. It is therefore intended that the present invention not be limited to the exact forms and details described and illustrated, but fall within the scope of the appended claims.

## Claims

1. A heat sink assembly comprising:
a thermally conductive support member configured to be attached to a heat source, the heat source being located within an enclosure;
a heat sink; and
an adjustable mechanism configured to moveably connect the thermally conductive support member to the heat sink, the adjustable mechanism permitting the heat source to be moved relative to the heat sink without requiring access within the enclosure to the adjustable mechanism.

2. The heat sink assembly of claim 1, further comprising a compression mechanism configured to provide a continuous force between the thermally conductive support member and the heat sink as the heat source is moved relative to the heat sink.

3. The heat sink assembly of claim 1, wherein the adjustable mechanism comprises a tongue and groove joint.

4. The heat sink assembly of claim 3, wherein the tongue and groove joint includes a groove on the thermally conductive support member that is configured to moveably fit on a rib on the heat sink.

5. The heat sink assembly of claim 2, wherein the compression mechanism comprises a pair of spring clips, a first end of each spring clip being secured to the heat sink and a second end of each spring clip being configured to provide a clamping force on the thermally conductive support member.

6. The heat sink assembly of claim 5, wherein the second end of each spring clip is configured to fit within a channel on the thermally conductive support member.

7. The heat sink assembly of claim 6, wherein each spring clip is configured to maintain a continuous clamping force to maintain the thermally conductive support member in thermal contact with the heat sink as the groove on the thermally conductive support member is moved along the rib on the heat sink when moving the heat source relative to the heat sink.

8. The heat sink assembly of claim 1, wherein the adjustable mechanism comprises a tube portion formed on the thermally conductive support member, the tube portion being configured to tightly fit onto a thermally conductive material layer surrounding a section of the heat sink rail.

9. The heat sink assembly of claim 8, wherein the tube portion is attached to or integral with the thermally conductive support member.

10. The heat sink assembly of claim 8, wherein the thermally conductive material layer is a thermal grease layer or a thermal paste or a fluid fill material.

11. The heat sink assembly of claim 8, wherein the thermally conductive material layer is a wavy ribbon material that is configured to compress when the tube is positioned over the friction layer.

12. The heat sink assembly of claim 2, wherein the compression mechanism comprises a pair of coil springs secured through a slot in the thermally conductive support member.

13. The heat sink assembly of claim 2, wherein the compression mechanism comprises a pair of spring washers secured through a slot in the thermally conductive support member.

14. The heat sink assembly of claim 1, further comprising a flexible thermal strap connected between the heat sink and the thermally conductive bracket.

15. A heat sink assembly for removal of heat from an object comprising:
an enclosure for housing the object, the object generating heat to be removed;
a thermally conductive support member configured to be attached to the object;
a heat sink rail attached to a removable panel of the enclosure, the removable panel serving as a heat sink; and
an adjustable mechanism configured to moveably connect the thermally conductive support member to the heat sink rail, the adjustable mechanism permitting the object to be moved relative to the heat sink rail without requiring access to the adjustable mechanism when the object is installed in the enclosure.

16. The heat sink assembly of claim 15, further comprising a compression mechanism configured to provide a continuous force between the thermally conductive support member and the heat sink rail as the object is moved relative to the heat sink rail.

17. A method of removing of heat from an object comprising:
providing an enclosure for housing the object, the object generating heat to be removed;
attaching a thermally conductive support member to the object;
attaching a heat sink rail to a removable panel of the enclosure, the removable panel serving as a heat sink; and
operating an adjustable mechanism for installing the object in the enclosure, the adjustable mechanism being configured for moveably connecting the thermally conductive support member to the heat sink rail, the adjustable mechanism permitting the object to be moved relative to the heat sink rail without requiring access to the adjustable mechanism when the object is installed in the enclosure.

18. A method of removing of heat from an object of claim 17, further comprising providing a compression mechanism for providing a continuous force between the thermally conductive support member and the heat sink rail as the object is moved relative to the heat sink rail.
